# FASCICULE DE BREVET EUROPEEN

(11) **EP 4 477 787 B1**
(45) Date de publication et mention de la délivrance du brevet: **18.11.2026**
(21) Numéro de dépôt: 24182185.9
(22) Date de dépôt: 14.06.2024
(51) Int. Cl.: C30B 25/18, C30B 29/04, C30B 25/20

(54) **PROCEDE DE FORMATION D'UNE COUCHE DE DIAMANT MONOCRISTALLIN, SUBSTRAT DE DIAMANT MONOCRISTALLIN ET UTILISATION DUDIT SUBSTRAT**
VERFAHREN ZUR HERSTELLUNG EINER MONOKRISTALLINEN DIAMANTSCHICHT, EINKRISTALLINES DIAMANTSUBSTRAT UND VERWENDUNG DES SUBSTRATS
METHOD FOR FORMING A SINGLE CRYSTAL DIAMOND LAYER, SINGLE CRYSTAL DIAMOND SUBSTRATE AND USE OF THE SAME

(30) Priorité: 14.06.2023 FR 2306048
(43) Date de publication de la demande: 18.12.2024
(73) Titulaire: Hiqute Diamond, 92100 Boulogne-Billancourt (FR)
(72) Inventeur: Gicquel, Alix, 14360 Trouville-Sur-Mer (FR); Duigou, Olivier, 91300 Massy (FR); PERRIN, Basile, 75016 PARIS (FR); GLAD, Xavier, 75016 PARIS (FR)
(74) Mandataire: A.P.I. Conseil

(56) Documents cités:
- EP-B1- 3 325 696
- FR-A1- 3 022 563
- BOUSSADI A ET AL: "Reduction of dislocation densities in single crystal CVD diamond by confinement in the lateral sector", DIAMOND AND RELATED MATERIALS, ELSEVIER SCIENCE PUBLISHERS , AMSTERDAM, NL, vol. 83, 13 February 2018 (2018-02-13), pages 162 - 169, XP085365248, ISSN: 0925-9635, DOI: 10.1016/J.DIAMOND.2018.02.010

## Description

### Domaine technique

L'invention concerne le domaine de la fabrication de diamant, plus spécifiquement la préparation de diamant monocristallin présentant une densité de défauts cristallins réduite.

### Technique antérieure

Ci-après, nous décrivons l'art antérieur connu à partir duquel l'invention a été développée.

Le diamant est un matériau qui présente des propriétés physiques particulièrement appréciées dans de nombreux domaines. En particulier, le diamant présente des propriétés inégalées en tant que matériau adapté pour l'optoélectronique, telles qu'une conductivité thermique élevée, une mobilité électron/trou élevée, une intensité de champ électrique de claquage diélectrique élevée, une faible perte diélectrique et une large structure de bande, une résistance aux radiations, une stabilité chimique élevée et d'excellentes propriétés optiques.

Le diamant monocristallin demeure l'un des matériaux les plus prometteurs pour la préparation de dispositifs optoélectroniques à haute puissance, haute fréquence, haute température et résistant aux environnements sévères et de haute tenue à la tension, de technologies quantiques et de fenêtres optiques.

En particulier, afin de mettre le diamant en pratique en tant que matériau pour des applications opto-électroniques, un substrat ou une plaquette de diamant monocristallin ayant peu de défauts cristallins, de contraintes en extension ou compressives et une grande homogénéité est requise pour la plupart des applications.

Pour permettre la réalisation de substrats de diamant monocristallin présentant de moins en moins de défauts cristallins, plusieurs méthodes de croissance ont vu le jour, parmi elles, les procédés de fabrication de plaque de diamant monocristallin par croissance homoépitaxiale latérale ont permis d'obtenir des substrats de diamant monocristallin de bonne qualité.

La principale difficulté technique est liée à la formation de défauts cristallins lors des phases de croissance et plus particulièrement de défauts étendus telles que des dislocations qui peuvent en outre générer des contraintes. L'apparition de dislocations peut être due à la présence d'impuretés ou de défauts cristallins mais également de contraintes.

Plusieurs techniques ont été développées pour tenter de limiter l'apparition de dislocations telles que les traitements de gravure chimique in-situ utilisant un plasma H₂/O₂, la gravure physique ex-situ avec une source de plasma à couplage inductif ou le polissage mécano-chimique du substrat de diamant monocristallin avant la croissance. Ces méthodes limitent voire annihilent la formation de nouvelles dislocations à l'interface à la reprise épitaxique en éliminant les dommages de polissage mécanique en surface. Néanmoins, les dislocations provenant de défauts existant directement dans le substrat de diamant monocristallin ne peuvent pas être facilement éliminées et se propagent inévitablement dans le sens de la croissance, conduisant à un diamant monocristallin avec une densité de dislocations relativement élevée et généralement comprise entre 10⁵ et 10⁷ dislocations/cm², voire plus.

La présence de ces dislocations affecte la propagation de la lumière et génère une biréfringence optique et une luminescence de fond indésirable, ce qui rend impossible l'utilisation du diamant monocristallin pour des fenêtres optiques ou certaines technologies électroniques ou quantiques.

Des solutions visant à résoudre en partie les problèmes évoqués précédemment ont vu le jour, notamment une première solution est décrite dans le brevet n°EP3325696 B1 qui propose la formation de fenêtres traversantes dans des substrats de diamant avant de procéder à une croissance latérale. L'article de Fernando Lloret et al. ; MPCVD Diamond Lateral Growth Through Microterraces to Reduce Threading Dislocations Density ; Phys. Status Solidi A 2017, 214, 1700242 propose d'utiliser l'effet des terrasses micrométriques sur la distribution des défauts étendus. L'évolution de ces défauts au cours de la croissance est déterminée en utilisant des couches très fines dopées au bore. Cette méthode, connue sous le nom d'approche stratigraphique, permet de déterminer l'orientation de la croissance tous les 100 nm. Cet article montre ainsi que les dislocations peuvent être redirigées loin des structures en terrasses, grâce à la croissance latérale. Il est possible de générer des zones exemptes de défauts cristallins en fonction de la taille des terrasses pour une direction de croissance selon la famille de plans {111}.

Une autre solution est également décrite dans l'article scientifique A. Boussadi et al. ; Reduction of dislocation densities in single crystal CVD diamond by confinement in the lateral sector ; Diamond & Related Materials 83 (2018) 162-169. Dans cette étude, des substrats de forme pyramidale avec un angle de 20° ayant à la fois leurs faces latérales et supérieures orientées selon la famille de plans {100} sont utilisées et l'effet des différentes conditions de croissance sur la propagation des dislocations est déterminé. Ainsi, le maintien d'un angle limite du secteur de croissance d'environ 45° et l'utilisation de densités de puissance modérées permet une croissance respective des faces supérieures et latérales tout en assurant un confinement des dislocations dans les régions latérales du substrat de diamant monocristallin.

Document D1 divulgue un procédé de formation d'un monocristal de matériau à partir d'un substrat monocristallin ayant une surface présentant une alternance de creux et d'élévations, comprenant des étapes de : a) former une couche de monocristal par croissance épitaxiale latérale entre les élévations, b) détecter des zones de défauts dans la couche de monocristal par gravure légère de la couche de monocristal, c) former un masque sur la couche de monocristal entre les zones de défauts détectées, d) graver la couche de monocristal munie du masque, de manière à former des creux dans les zones de défauts de la couche et des élévations hors des zones de défauts de la couche, e) répéter l'étape a).

Bien que ces solutions permettent de limiter l'apparition de dislocations lors de la croissance d'un substrat de diamant monocristallin, sont peu pratiques de mise en oeuvre et ne permettent pas de générer des substrats de diamant monocristallin de qualité suffisante pour des applications opto-électroniques. En effet, les solutions proposées dans l'état de l'art permettent l'obtention de substrats de diamant monocristallin assez contraints après croissance et qui comprennent des dislocations supérieures à 3*10³ dislocations/cm². En outre, les solutions présentées précédemment ne permettent pas de réaliser des substrats de l'ordre du cm² ou plus.

Ainsi, il existe un besoin pour la fourniture de substrats de diamant monocristallin de 1 cm² et plus qui présentent une densité de dislocations bien inférieure et dont les contraintes compressives ou extensives sont fortement réduites.

L'invention a pour but de remédier aux inconvénients de l'art antérieur. En particulier, l'invention a pour but de proposer un procédé de formation d'une couche de diamant monocristallin présentant une densité de dislocations inférieure ou égale à 10³ dislocations par cm², ledit procédé permettant d'assurer la formation de substrats de diamant monocristallin de haute qualité, c'est-à-dire avec une densité de défauts cristallins et par voie de conséquence de contraintes limitées par rapport aux solutions existantes.

### Résumé de l'invention

L'invention vise à pallier ces inconvénients. Ce qui suit présente un résumé simplifié d'aspects, de modes de réalisation et d'exemples sélectionnés de la présente invention dans le but de fournir une compréhension de base de l'invention. Cependant, ce résumé ne constitue pas un aperçu exhaustif de tous les aspects, modes de réalisation et exemples de l'invention. Son seul but est de présenter des aspects, modes de réalisation et exemples sélectionnés de l'invention sous une forme concise en guise d'introduction à la description plus détaillée des aspects, modes de réalisation et exemples de l'invention qui suivent le résumé.

L'invention vise en particulier un procédé de formation d'une couche de diamant monocristallin présentant une densité de défauts cristallins inférieure ou égale à 10³ défauts cristallins par cm² comprenant les étapes suivantes :
- fourniture d'un substrat de diamant monocristallin ayant une densité de défauts cristallins initiale supérieure à 10³ défauts cristallins par cm², le substrat de diamant monocristallin présentant un angle de désorientation, par rapport à la face exacte du substrat de diamant monocristallin supérieur à 0° et inférieur ou égal à 10°,
- première micro structuration d'une surface de croissance du substrat de diamant monocristallin par ablation laser non traversante, l'étape de micro structuration comportant la réalisation de premières figures de gravure de sorte que chaque première figure de gravure comprend une ouverture d'une largeur prédéterminée et est délimitée par au moins une paroi, chacune des premières figures de gravure présentant en outre une profondeur d'au moins 30 µm, ladite profondeur étant supérieure à la largeur de l'ouverture ;
- première croissance homoépitaxiale, dans un réacteur par dépôt chimique en phase vapeur assisté par plasma ou par filament chaud, la première croissance étant réalisée :
   ∘ normalement par rapport à la surface de croissance de manière à former une première couche de diamant monocristallin comportant les défauts cristallins de la surface de croissance, et
   ∘ latéralement par rapport à la paroi délimitant la première gravure, de manière à former une deuxième couche de diamant monocristallin comportant les défauts cristallins de la paroi confinés dans la première figure de gravure et une cavité, de sorte que, la première figure de gravure est recouverte par une troisième couche de diamant monocristallin présentant une densité de défauts cristallins inférieure ou égale à 10³ dislocations par cm²,

- deuxième micro structuration du substrat de diamant monocristallin par ablation laser non traversante, ladite deuxième étape de micro structuration comportant la réalisation de deuxièmes figures de gravure au niveau de la première couche de diamant monocristallin comportant les défauts cristallins de la surface de croissance, chaque deuxième figure de gravure comprend une ouverture d'une largeur prédéterminée et est délimitée par au moins une paroi, chacune des deuxièmes figures de gravure présente en outre une profondeur d'au moins 30 µm, ladite profondeur étant supérieure à la largeur de l'ouverture,
- deuxième croissance homoépitaxiale d'une autre deuxième couche de diamant monocristallin, dans un réacteur par dépôt chimique en phase vapeur assisté par plasma ou par filament chaud, la deuxième croissance étant réalisée latéralement par rapport à la paroi délimitant la deuxième figure de gravure, l'autre deuxième couche de diamant monocristallin comportant les défauts cristallins de la paroi confinés dans la deuxième figure de gravure et une cavité, de sorte que, la deuxième figure de gravure est recouverte par une troisième couche de diamant monocristallin présentant une densité de défauts cristallins inférieure ou égale à 10³ défauts cristallins par cm².

Selon d'autres caractéristiques optionnelles du procédé de formation d'une couche de diamant monocristallin, ce dernier peut inclure facultativement une ou plusieurs des caractéristiques suivantes, seules ou en combinaison :
- la surface de croissance est une face cristallographique (100) désorientée par rapport à une famille de faces cristallographiques {100} parallèles à une des faces latérales du substrat de diamant monocristallin.
- la surface de croissance est une face cristallographique (100) désorientée par rapport à une famille de faces cristallographiques {110} ou à une famille de faces cristallographiques {113}.
- une étape de croissance homoépitaxiale normale, dans le réacteur par dépôt chimique en phase vapeur assisté par plasma ou par filament chaud, de sorte que la troisième couche de diamant monocristallin atteigne une épaisseur d'au moins 500 µm.
- une étape de découpe de la troisième couche de diamant monocristallin, de préférence au laser.
- une étape de recuit de la troisième couche de diamant monocristallin à une température allant de 1500°C à 2300°C.
- au moins une étape de recuit intermédiaire du substrat de diamant monocristallin à une température allant de 1500°C à 2300°C, l'étape de recuit intermédiaire étant mise en œuvre entre l'étape de fourniture et l'étape de première micro structuration, entre la première croissance homoépitaxiale et l'étape de deuxième micro structuration et/ou entre l'étape de deuxième micro structuration et l'étape de deuxième croissance homoépitaxiale.
- la largeur de l'ouverture des première et deuxième figures de gravure est comprise entre 20 µm et 200 µm.
- une étape de préparation, préalable à la deuxième étape de micro-structuration, de la surface de croissance du substrat de diamant monocristallin par découpe laser ou par polissage, lorsque l'angle de désorientation est inférieur à un seuil prédéterminé, de façon à induire une désorientation au moins égale au seuil prédéterminé.
- les étapes de première et/ou deuxième micro-structuration et de première et/ou deuxième croissance homoépitaxiale sont répétées jusqu'à l'obtention d'une densité de défauts cristallins, dans la troisième couche de diamant monocristallin, inférieure ou égale à un seuil prédéterminé, de préférence inférieure ou égale à 10³ défauts cristallins par cm² et de façon préférée inférieure ou égale à 5*10² défauts cristallins par cm².

Selon un deuxième objet, l'invention porte sur un substrat de diamant monocristallin comprenant une couche de diamant monocristallin, ladite couche de diamant monocristallin ayant été obtenue par :
- formation de premières figures de gravure par micro structuration d'une surface de croissance du substrat de diamant monocristallin par ablation laser non traversante, de sorte que chaque première figure de gravure comprend une ouverture d'une largeur prédéterminée et est délimitée par au moins une paroi, chacune des premières figures de gravure présentant en outre une profondeur d'au moins 30 µm, ladite profondeur étant supérieure à la largeur de l'ouverture,
- une première croissance homoépitaxiale, la première croissance comprenant :
   ∘ une croissance normale par rapport à la surface de croissance de manière à former une première couche de diamant monocristallin comportant les défauts cristallins de la surface de croissance, et
   oune croissance latérale par rapport à la paroi délimitant la première gravure, de manière à former une deuxième couche de diamant monocristallin comportant les défauts cristallins de la paroi confinés dans la première figure de gravure et une cavité, de sorte que, la première figure de gravure est recouverte par une troisième couche de diamant monocristallin présentant une densité de défauts cristallins inférieure ou égale à 10³ dislocations par cm²,
- formation de deuxièmes figures de gravure par micro structuration de la première couche de diamant monocristallin par ablation laser non traversante, de sorte que chaque deuxième figure de gravure comprend une ouverture d'une largeur prédéterminée et est délimitée par au moins une paroi, chacune des deuxièmes figures de gravure présente en outre une profondeur d'au moins 30 µm, ladite profondeur étant supérieure à la largeur de l'ouverture,
- une deuxième croissance homoépitaxiale d'une autre deuxième couche de diamant monocristallin, la deuxième croissance étant réalisée latéralement par rapport à la paroi délimitant la deuxième figure de gravure, l'autre deuxième couche de diamant monocristallin comportant les défauts cristallins de la paroi confinés dans la deuxième figure de gravure et une cavité, de sorte que, la deuxième figure de gravure est recouverte par une troisième couche de diamant monocristallin présentant une densité de défauts cristallins inférieure ou égale à 10³ défauts cristallins par cm².

Selon d'autres caractéristiques optionnelles du substrat de diamant monocristallin, ce dernier peut inclure facultativement une ou plusieurs des caractéristiques suivantes, seules ou en combinaison :
- les premières et deuxièmes figures de gravure non traversantes sont réalisées sur toute la surface de croissance.
- la largeur de l'ouverture des première et deuxième figures de gravure est comprise entre 20 µm et 200 µm.

Selon un troisième objet, l'invention porte sur une utilisation d'un substrat de diamant monocristallin selon l'invention pour l'obtention d'une couche de diamant monocristallin adaptée en tant que substrat pour des technologies quantiques, pour la fabrication d'une fenêtre optique, d'un substrat pour semi-conducteur ou pour la gestion thermique.

### Brève description des dessins

D'autres caractéristiques et avantages de l'invention seront mieux compris à la lecture de la description qui va suivre et en référence aux dessins annexés, donnés à titre illustratif et nullement limitatif.
[Fig. 1] La figure 1 représente un schéma d'un procédé de formation d'une couche de diamant monocristallin selon l'invention. Les étapes encadrées en pointillées sont facultatives.
[Fig. 2] La figure 2 représente une illustration d'un procédé de formation d'une couche de diamant monocristallin selon l'invention.
[Fig. 3] La figure 3 est une photo montrant une coupe d'un substrat de diamant monocristallin comprenant une couche de diamant monocristallin obtenue selon l'invention et ayant été traité par ablation laser directive.
[Fig. 4] La figure 4 est une photo d'un substrat de diamant monocristallin selon l'invention vue de dessus, comprenant une couche de diamant monocristallin formée par un procédé de formation selon l'invention, observé en microscopie optique en transmission après attaque plasma H₂/O₂.
Les figures ne respectent pas nécessairement les échelles, notamment en épaisseur, et ce à des fins d'illustration.

Des aspects de la présente invention sont décrits en référence à des organigrammes et/ou à des schémas fonctionnels de procédés selon des modes de réalisation de l'invention.

Sur les figures, les organigrammes et les schémas fonctionnels illustrent l'architecture, la fonctionnalité et le fonctionnement d'implémentations possibles de systèmes, de procédés selon divers modes de réalisation de la présente invention. A cet égard, chaque bloc dans les organigrammes ou blocs-diagrammes peut représenter un système, un dispositif, un module ou un code, qui comprend une ou plusieurs instructions exécutables pour mettre en œuvre la ou les fonctions logiques spécifiées. Dans certaines implémentations, les fonctions associées aux blocs peuvent apparaître dans un ordre différent que celui indiqué sur les figures. Par exemple, deux blocs montrés successivement peuvent, en fait, être mis en œuvre sensiblement simultanément, ou les blocs peuvent parfois être mis en œuvre dans l'ordre inverse, en fonction de la fonctionnalité impliquée. Chaque bloc des schémas de principe et/ou de l'organigramme, et des combinaisons de blocs dans les schémas de principe et/ou l'organigramme, peuvent être mis en œuvre par des systèmes matériels spéciaux qui exécutent les fonctions ou actes spécifiés ou effectuer des combinaisons de matériel spécial et d'instructions informatiques.

### Description des modes de réalisation

Ci-après, nous décrivons un résumé de l'invention et le vocabulaire associé, avant de présenter les inconvénients de l'art antérieur, puis enfin de montrer plus en détail comment l'invention y remédie.

Dans la suite de la description, l'expression « **substrat de diamant monocristallin** » peut correspondre à un bloc de diamant monocristallin de plus de 3 µm d'épaisseur et de surface allant de 1 mm² à plus de 800 cm². Le terme « **substrat** » au sens de l'invention peut correspondre aux éléments sur lesquels les couches ou films de diamant croissent. Il s'agit de couches monocristallines de monocristaux de diamant naturel ou produits par procédé haute pression-haute température (HPHT) ou encore produits par processus CVD (pour chemical vapor deposition ou dépôt chimique en phase vapeur assisté par plasma ou par filament chaud).

Lorsque l'expression **« face d'orientation cristallographique de la famille** » est utilisée, elle fait généralement référence à une **famille de plans cristallins.** Les plans cristallins qui présentent une forme cristalline particulière dont la surface est sensiblement plane et limitant un cristal, qui se note par convention entre accolades. Cela inclut toutes les variantes de position que peut prendre la face d'orientation cristallographique dans un cristal. A titre d'exemple, la famille de la face d'orientation cristallographique de la famille {100} inclut également les variantes, positives et négatives, telles que les faces cristallographiques (010) et (001). Ces faces cristallographiques sont conventionnellement définies par trois indices de Miller notés entre parenthèse « (hkl) », h, k et l pouvant être des nombres entiers positifs ou négatifs. Afin d'éviter toute confusion avec des éléments référencés dans les figures, la mention des faces cristallographiques dans les revendications, par exemple de type (100), est faite sans les parenthèses.

Une « **structure en terrasses** » selon l'invention peut correspondre à une structure étagée comprenant des marches caractérisées par une première orientation cristallographique et des terrasses caractérisées par une deuxième orientation cristallographique, la deuxième orientation cristallographique est de préférence différente de la première orientation cristallographique. Les marches d'une structure en terrasses sont sensiblement linéaires et parallèles entre elles, tandis que les terrasses sont sensiblement linéaires et parallèles entre elles. A titre d'exemple illustratif, les terrasses sont formées par des faces d'orientation cristallographiques de la famille de plans {100}.

Le terme « **croissance** » au sens de l'invention peut correspondre à l'étape ou aux étapes de dépôt de carbone sous forme sp3 de diamant cristallin (monocristallin) contribuant à la production d'une couche de diamant monocristallin. Les conditions de croissance et paramètres de dépôt représentent un ensemble de valeurs des variables : pression, puissance microonde injectée, débit total des gaz, débit du précurseur carboné, débit d'impuretés et de dopant, composition du gaz de résistance thermique et leur débit, température de la couche ou des couches en croissance pour un réacteur donné.

Le terme « **diamant** » au sens de l'invention peut correspondre à une ou plusieurs couches de diamant monocristallin plus au moins épaisses, résultant du dépôt de carbone sous forme sp3 de diamant cristallin (monocristallin).

L'expression **« couche de diamant »** au sens de l'invention correspond à une couche (ou un film) de diamant monocristallin formée après nucléation / condensation sur une surface de diamant monocristallin ou d'un autre matériau. Au sens de l'invention, l'obtention de diamant monocristallin se fait généralement par épaississement en hauteur et/ou en largeur d'un monocristal de diamant souche (ou substrat de diamant monocristallin) provenant d'un monocristal de diamant naturel ou produit par procédé haute pression-haute température (HPHT) ou produit par CVD (pour « chemical vapor deposition » assisté par plasma ou par filament chaud).

Le terme « **plasma** » au sens de l'invention peut correspondre à la production, à partir d'une décharge électrique dans un gaz composé d'un mélange, d'un milieu globalement neutre électriquement mais contenant des ions et des électrons ainsi que des fragments d'espèces gazeuses dissociées ainsi que des molécules stables.

L'expression « **désorientation cristallographique** » (notée δ), au sens de l'invention, peut correspondre à la présence d'un angle de désorientation caractérisant la surface du germe-substrat ou du substrat par rapport à un plan exact, par exemple un plan cristallin de la famille de plans {100}.

Le terme « **sensiblement** » au sens de l'invention s'entend d'une valeur variant de moins de 30 % par rapport à la valeur comparée, de préférence de moins de 20 %, de façon encore plus préférée de moins de 10 %. Lorsque sensiblement identique est utilisé pour comparer des formes alors la forme vectorisée varie de moins de 30 % par rapport à la forme vectorisée comparée, de préférence de moins de 20 %, de façon encore plus préférée de moins de 10 %. En particulier, lorsque sensiblement identique est utilisé pour comparer des angles alors les valeurs d'angles ne sont pas différentes de plus de 10°, de façon préférée de plus de 5°, de façon encore plus préférée de plus de 2° et de façon encore plus préférée de plus de 1°.

Pour de nombreuses applications industrielles, des couches de diamant monocristallin de grande qualité sont attendues. Il a déjà été proposé quelques méthodes pour produire des couches de diamant monocristallin qui présentent une densité de dislocations réduite. Toutefois les diamants monocristallins obtenus selon ces méthodes présentent généralement un nombre de défauts cristallins, et plus particulièrement de dislocations, toujours trop importants. Par ailleurs les contraintes restent généralement importantes. La demanderesse a développé une nouvelle méthode qui limite l'apparition de ces défauts cristallins et réduit substantiellement les contraintes dans les substrats réalisés.

La demanderesse propose d'utiliser des substrats de diamant monocristallin micro structurés, par la réalisation de figures de gravure, en utilisant un procédé d'ablation laser, de préférence directif, qui présentent un rapport entre leur profondeur et leur largeur prédéterminé tout en les positionnant selon un angle de désorientation prédéfini afin de générer une couche de diamant monocristallin de haute qualité. Cela permet de bloquer la propagation des dislocations se propageant dans la direction normale au substrat de diamant monocristallin initial, et ainsi la formation de substrats de diamant monocristallin de haute qualité, c'est-à-dire avec une densité de dislocations inférieure ou égale à 10³ ou de manière préférée inférieure ou égale à 5*10² dislocations par cm². En particulier, l'invention propose de procéder à une succession de micro-structuration d'une surface de croissance d'un substrat de diamant monocristallin et de croissance latérale selon une succession de matrices positionnées en décalée afin de générer des figures de gravure de largeur et de profondeur prédéterminées et assurer la formation d'une couche monocristalline de qualité optimale avec peu de dislocations par unité de surface. L'invention inclut également, de manière optionnelle, la mise en œuvre d'une ou plusieurs étapes de recuit à différentes étapes du procédé selon l'invention afin de réduire encore plus l'apparition de contraintes dans les couches de diamant monocristallin réalisées selon l'invention.

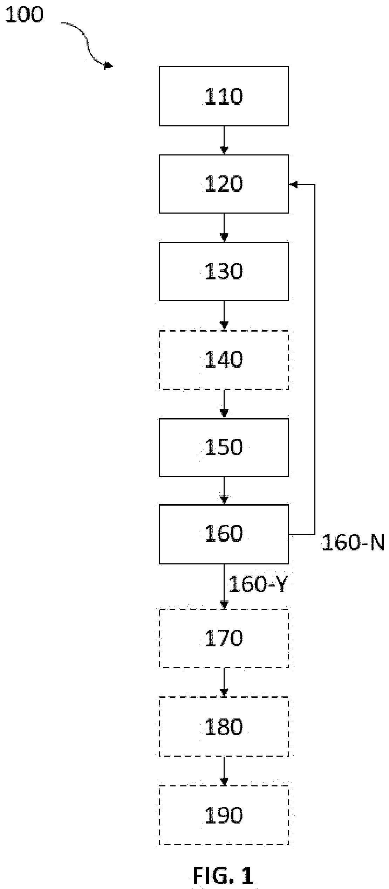

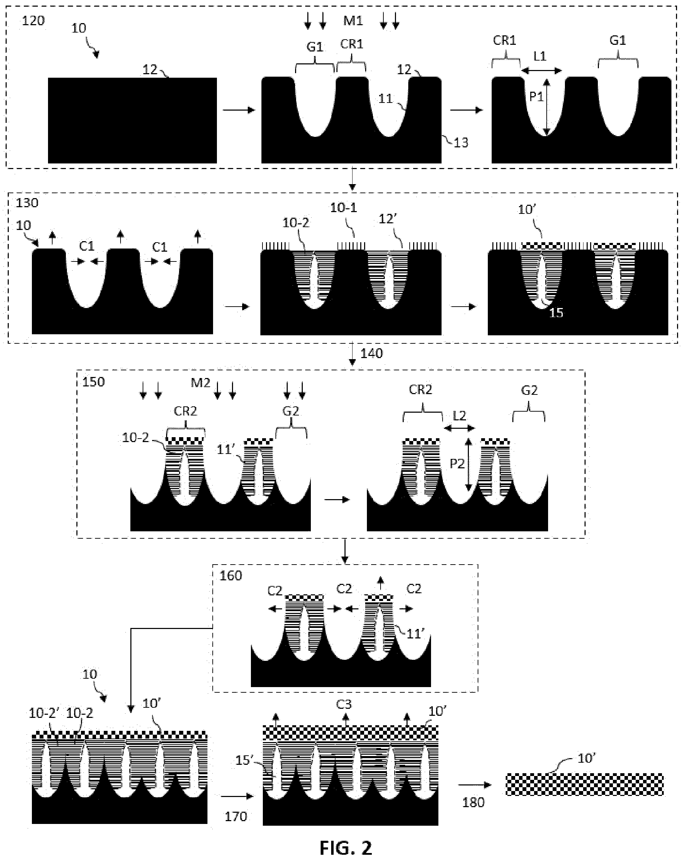

Ainsi, comme illustrés en figures 1 et 2, l'invention concerne un procédé de formation 100 d'une couche de diamant monocristallin présentant une densité de dislocations inférieure ou égale à 10³ dislocations par cm², de préférence inférieure ou égale à 5*10² dislocations par cm², le procédé comprend une étape de fourniture 110 d'un substrat de diamant monocristallin ayant une densité de dislocation initiale supérieure à 10³ dislocations par cm², une première étape de micro-structuration 120, une première étape de croissance C1 homoépitaxiale 130, une deuxième étape de micro-structuration 150 et une deuxième étape de croissance C2 homoépitaxiale 160.

Un des objectifs de l'invention est de permettre d'améliorer la qualité d'une couche de diamant monocristallin à partir de substrats de qualité moindre, généralement inconstante, commercialisés par des entreprises spécialisées. Selon l'invention, l'étape de fourniture 110 du substrat de diamant monocristallin 10 implique que ce-dernier présente une densité de défauts cristallins initiale supérieure à 10³ défauts cristallins par cm². Dans l'invention, le substrat de diamant monocristallin 10 présente un angle de désorientation δ, par rapport à la face exacte du substrat de diamant monocristallin supérieur à 0° et inférieur ou égal à 10°.

A titre d'exemples illustratifs, l'angle de désorientation peut être d'au moins 0,1°, de préférence au moins 0,5°, de façon plus préférée au moins 1°, de façon encore plus préférée d'au moins 2°. L'angle de désorientation peut être d'au plus 9,9°, de préférence au plus 9,5°, de façon plus préférée au plus 9°, de façon encore plus préférée d'au plus 8°. Ainsi, l'angle de désorientation peut par exemple aller de 0,1° à 9,9°, de préférence aller de 0,5° à 9,5°, de façon plus préférée aller de 1° à 9°, de façon encore plus préférée aller de 2° à 8°.

Dans un mode de réalisation optionnel de l'invention, le substrat de diamant monocristallin 10 peut comprendre une structure étagée ou structure en terrasses qui présente des faces d'orientation cristallographique de la famille de plans {100} ou encore de la famille de plans {100} et {113}. La structure en terrasse peut présenter des angles de désorientation, en lien avec chaque terrasse de la structure en terrasses, sensiblement identiques ou à tout le moins relativement proches. Les étapes de croissance homoépitaxiale décrites pourront ainsi être mises en œuvre par mécanisme d'écoulement de marches afin de limiter l'apparition de défauts, et plus particulièrement la formation de macles, limitant ainsi les dislocations.

Un procédé de formation 100 selon l'invention comprend en outre une étape de première micro structuration 120 d'une surface de croissance 12 du substrat de diamant monocristallin 10 par ablation laser non traversante.

Selon l'invention, l'étape de micro structuration 120 comporte la réalisation de premières figures de gravure G1. Chaque première figure de gravure G1 comprend une ouverture d'une largeur L1 prédéterminée et est délimitée par au moins une paroi 11, chacune des premières figures de gravure G1 présente en outre une profondeur P1 d'au moins 30 µm, ladite profondeur P1 étant supérieure à la largeur L1 de l'ouverture.

Comme présenté en figure 2, l'ablation laser non traversante a pour objectif de retirer une partie de la matière du substrat de diamant monocristallin 10 de manière contrôlée, selon une première matrice de retrait M1 prédéterminée, afin de former des figures de gravure positionnées les unes par rapport aux autres de manière prédéfinie. Les premières figures de gravure G1 sont formées par une paroi 11 et séparées par une partie de la surface de croissance 12 n'ayant pas fait l'objet de l'ablation laser et prenant généralement la forme de créneaux CR1. Comme présenté dans la figure 2, la paroi 11 de la première figure de gravure G1 correspond au contour décrivant l'intérieur de la première figure de gravure G1 après ablation.

De manière avantageuse, l'ablation laser non traversante peut consister en une ablation laser directive, du type connu, afin d'obtenir des premières figures de gravures G1 de dimensions sensiblement identiques sur toute la surface de croissance 12.

A titre d'exemple illustratif, la surface de croissance 12 peut être une face cristallographique (100) désorientée par rapport à une famille de faces cristallographiques {100} parallèles à une des faces latérales 13 du substrat de diamant monocristallin 10.

Dans un autre exemple illustratif, la surface de croissance 12 peut être une face cristallographique (100) désorientée par rapport à une famille de faces cristallographiques {110} ou à une famille de faces cristallographiques {113}.

Toujours dans l'invention, le procédé de formation 100 d'une couche de diamant monocristallin 10' comprend une étape de première croissance C1 homoépitaxiale 130, dans un réacteur par dépôt chimique en phase vapeur assisté par plasma ou par filament chaud.

L'étape de première croissance C1 homoépitaxiale 130 est réalisée normalement et latéralement par rapport à la surface de croissance 12. La croissance normale s'effectue de manière sensiblement perpendiculaire à un plan formé par la surface de croissance 12, de manière à former une première couche de diamant monocristallin 10-1 comportant les défauts cristallins de la surface de croissance 12. En effet, lors de la première croissance C1, les défauts cristallins de la surface de croissance 12 vont se propager dans la première couche de diamant monocristallin 10-1.

L'étape de première croissance C1 homoépitaxiale 130 est en outre réalisée latéralement par rapport à la paroi 11 délimitant la première gravure G1, de manière à former une deuxième couche de diamant monocristallin 10-2 comportant les défauts cristallins de la paroi 11 confinés dans la première figure de gravure G1 et une cavité 15.

Comme détaillé précédemment, les premières figures de gravure G1 présentent une profondeur P1 d'au moins 30 µm. Cela permet, lors de la première croissance C1 latérale, de permettre la formation de la cavité 15 qui décrit un espace creux qui s'étend selon un axe longitudinal depuis la partie la plus profonde de la première gravure G1 et sur au moins 5 % de la profondeur de la première figure de gravure G1, de manière préférée au moins 15 %. De manière préférée, la cavité 15 représente au moins 5 % de l'espace de la première gravure G1, de manière préférée au moins 10 %.

La première croissance C1 homoépitaxiale 130 latérale permet ainsi de recouvrir la première figure de gravure G1 par une troisième couche de diamant monocristallin 10' présentant une densité de défauts cristallins inférieure ou égale à 10³ dislocations par cm². En effet, la formation de la cavité 15 permet de bloquer la propagation d'une partie des défauts cristallins présents dans le substrat de diamant monocristallin 10 et d'en limiter la présence dans la troisième couche de diamant monocristallin 10'.

Afin de favoriser une croissance latérale par rapport à la paroi 11, les conditions de croissance peuvent comprendre la génération d'une pression comprise entre 50 hPa et 400 hPa au sein du réacteur, l'injection de microondes à une puissance comprise par exemple entre 1 kW et 50 kW (ou plus), selon le type de générateur utilisé (fréquence utilisée), l'injection de gaz, par exemple à un débit total d'au moins 100 standard cm³ par minute (sccm), de préférence d'au moins 1000 standard cm³ par minute (sccm), les gaz comprenant par exemple du méthane, de l'argon et du dihydrogène ou un mélange de tout ou partie de ces gaz, et des additifs tels que oxygène, azote, bore, phosphore et argon, ou encore des halogènes et la mise en fonctionnement de systèmes de refroidissement de l'enceinte, du substrat pour contrôler la température de la surface de croissance dans un intervalle allant de préférence de 750°C à 1250°C.

Dans un mode de réalisation du procédé de formation 100 d'une couche de diamant monocristallin 10', celui-ci peut inclure une étape de préparation 140 de la surface de croissance 12 du substrat de diamant monocristallin 10 par découpe laser ou par polissage. L'étape de préparation 140 peut être mise en œuvre lorsque l'angle de désorientation est inférieur à un seuil prédéterminé de façon à induire une désorientation au moins égale au seuil prédéterminé.

Selon l'invention, le procédé de formation 100 d'une couche de diamant monocristallin 10' comprend une deuxième micro structuration 150 du substrat de diamant monocristallin 10 par ablation laser non traversante.

La deuxième étape de micro structuration 150 comporte la réalisation des deuxièmes figures de gravure G2 prédéterminées, de préférence selon une deuxième matrice de retrait M2, au niveau de la première couche de diamant monocristallin 10-1 comportant les défauts cristallins de la surface de croissance 12, chaque deuxième figure de gravure G2 comprend une ouverture d'une largeur L2 prédéterminée et est délimitée par au moins une paroi 11', chacune des deuxièmes figures de gravure G2 présente en outre une profondeur P2 d'au moins 30 µm, ladite profondeur P2 étant supérieure à la largeur L2 de l'ouverture.

Les deuxièmes figures de gravure G2 sont formées par une paroi 11' et séparées par la deuxième couche de diamant monocristallin 10-2 surmontée par la troisième couche de diamant monocristallin 10', lesdites deuxième et troisième couches pouvant prendre la forme d'un créneau CR2 comme indiqué à titre d'exemple en figure 2. Comme présenté dans la figure 2, la paroi 11' de la deuxième figure de gravure G2 correspond au contour décrivant l'intérieur de la deuxième figure de gravure G2 après ablation et est notamment formée par la deuxième couche de diamant monocristallin 10-2 et par le substrat de diamant monocristallin 10.

A titre d'exemple illustratif, les figures de gravure G1, G2 peuvent être réalisées avec un laser présentant une longueur d'onde inférieure ou égale à 1 µm.

En outre, dans un mode de réalisation particulier, la durée du pulse du laser, lors de la formation des première et deuxième gravures G1, G2 des étapes de première et deuxième micro structuration 120, peut être de 200 ns.

Selon un mode de réalisation optionnel, les première et deuxième figures de gravure G1, G2 peuvent prendre diverses formes en fonction de la puissance du laser utilisé, de manière préférée, les figures de gravure G1, G2 peuvent prendre la forme d'une courbe Gaussienne.

Le procédé de formation 100 d'une couche de diamant monocristallin 10' selon l'invention comprend en outre une deuxième croissance C2 homoépitaxiale 160 d'une autre deuxième couche de diamant monocristallin 10-2', dans un réacteur par dépôt chimique en phase vapeur assisté par plasma ou par filament chaud.

La deuxième croissance C2 homoépitaxiale 160 latérale est réalisée latéralement par rapport à la paroi 11' délimitant la deuxième figure de gravure G2. L'autre deuxième couche de diamant monocristallin 10-2' comporte les défauts cristallins de la paroi 11' confinés dans la deuxième figure de gravure G2 et une cavité 15', de sorte que, la deuxième figure de gravure G2 est recouverte par une troisième couche de diamant monocristallin 10' présentant une densité de défauts cristallins inférieure ou égale à 10³ défauts cristallins par cm².

Afin de favoriser la deuxième croissance C2 homoépitaxiale 160 latérale par rapport à la paroi 11' de la deuxième figure de gravure G2, les conditions de croissance peuvent comprendre la génération d'une pression comprise entre 50 hPa et 400 hPa au sein du réacteur, l'injection de microondes à une puissance comprise par exemple entre 1 kW et 50 kW (ou plus), selon le type de générateur utilisé (fréquence utilisée), l'injection de gaz, par exemple à un débit total d'au moins 100 standard cm³ par minute (sccm), de préférence d'au moins 1000 standard cm³ par minute (sccm), les gaz comprenant par exemple du méthane, de l'argon et du dihydrogène ou un mélange de tout ou partie de ces gaz, et des additifs tels que oxygène, azote, bore, phosphore et argon, ou encore des halogènes et la mise en fonctionnement de systèmes de refroidissement de l'enceinte, du substrat pour contrôler la température de la surface de croissance dans un intervalle allant de préférence de 750°C à 1250°C.

Dans un mode de réalisation optionnel d'un procédé de formation 100 d'une couche de diamant monocristallin 10' selon l'invention, les étapes de première et/ou de deuxième micro-structuration 120, 150 et de première et/ ou deuxième croissance homoépitaxiale 130, 160 peuvent être répétées jusqu'à l'obtention d'une densité de défauts cristallins, dans la troisième couche de diamant monocristallin 10', inférieure ou égale 160-Y à un seuil prédéterminé, de préférence inférieure ou égale à 10³ défauts cristallins par cm² et de façon préférée inférieure ou égale à 5*10² défauts cristallins par cm². Notamment, une étape de caractérisation des défauts cristallins de la couche de diamant monocristallin 10' peut être mise en œuvre, par des techniques connues, et si la densité de défauts cristallins, dans la troisième couche de diamant monocristallin 10', est supérieure à un seuil prédéterminé 160-N, les étapes de première et/ou de deuxième micro-structuration 120, 150 et de première et/ou deuxième croissance homoépitaxiale 130, 160 sont répétées. De manière avantageuse, les étapes de première et deuxième micro-structuration et de première et deuxième croissance homoépitaxiale latérale peuvent être répétées entre une et vingt fois, de préférence entre une et quatre fois.

En complément, le procédé de formation 100 d'une couche de diamant monocristallin 10' selon l'invention peut comprendre une étape de croissance C3 homoépitaxiale normale 170, dans le réacteur par dépôt chimique en phase vapeur assisté par plasma ou par filament chaud, de sorte que la troisième couche de diamant monocristallin 10' atteigne une épaisseur d'au moins 500 µm. En effet, en fonction des applications à laquelle est destinée la couche de diamant monocristallin 10' ou à tout le moins pour favoriser la séparation de couche de diamant monocristallin 10', une croissance homoépitaxiale normale 170 supplémentaire pourra être nécessaire.

Afin de récupérer la couche de diamant monocristallin 10', le procédé de formation 100 selon l'invention peut comprendre une étape de découpe 180 de la troisième couche de diamant monocristallin 10', de préférence au laser.

Pour réduire les défauts cristallins et plus particulièrement les contraintes dans la troisième couche de diamant monocristallin 10', le procédé de formation 100 selon l'invention peut comprendre une étape de recuit 190 de la troisième couche de diamant monocristallin 10', après découpe 180, à une température allant de 1500°C à 2300°C, de préférence de 1500°C à 1800°C, de manière encore plus préférée de 1800°C à 2000°C et de manière encore plus préférée de 2000°C à 2300°C pendant une durée allant de 1h à 72h, de préférence de 5 min à 1h et de manière encore plus préférée une durée inférieure à 5 min.

De manière avantageuse, l'étape de recuit 190 de la troisième couche de diamant monocristallin 10' peut être effectuée à une température allant de 1500°C à 1800 °C pendant une durée allant de 10 heures à 24 heures. Cela permet de réduire les contraintes de près de 50%.

Pour réduire les défauts cristallins et plus particulièrement les contraintes, le procédé de formation 100 d'une couche de diamant monocristallin 10' peut comprendre une ou plusieurs étapes de recuit intermédiaire (non représentées sur les figures). Au moins une étape de recuit intermédiaire peut être mise en œuvre après l'étape de fourniture 110 d'un substrat de diamant monocristallin 10, après l'étape de première micro structuration 120, après l'étape de première croissance C1 homoépitaxiale 130, après l'étape de deuxième micro structuration 150, après l'étape de deuxième croissance C2 **homoépitaxiale** 160 et/ou après l'étape de croissance C3 homoépitaxiale normale 170. A l'instar de l'étape de recuit 190, la ou les étapes de recuit intermédiaire peuvent être mise en œuvre à une température allant de 1500°C à 2300°C, de préférence de 1500°C à 1800°C, de manière encore plus préférée de 1800°C à 2000°C et de manière encore plus préférée de 2000°C à 2300°C pendant une durée allant de 1h à 72h, de préférence de 5 min à 1h et de manière encore plus préférée une durée inférieure à 5 min.

La combinaison des étapes de première et deuxième micro structuration 120, 150, de première et deuxième croissance C1, C2 homoepitaxiale 140, 160 et de recuit 190 et/ou de recuit(s) intermédiaire conduit à une réduction substantielle des dislocations et des contraintes dans la couche de diamant monocristallin 10'.

Selon un deuxième objet, l'invention porte sur un substrat de diamant monocristallin 10 comprenant une couche de diamant monocristallin 10', ladite couche de diamant monocristallin 10' ayant été obtenue par un procédé de formation 100 d'une couche de diamant monocristallin 10' selon l'invention.

Selon un troisième objet, l'invention porte sur un substrat de diamant monocristallin 10 comprenant une couche de diamant monocristallin 10', ladite couche de diamant monocristallin 10' ayant été obtenue par :
- formation de premières figures de gravure G1 par micro structuration d'une surface de croissance 12 du substrat de diamant monocristallin 10 par ablation laser non traversante, de sorte que chaque première figure de gravure G1 comprend une ouverture d'une largeur L1 prédéterminée et est délimitée par au moins une paroi 11, chacune des premières figures de gravure G1 présentant en outre une profondeur P1 d'au moins 30 µm, ladite profondeur P1 étant supérieure à la largeur L1 de l'ouverture,
- une première croissance C1 homoépitaxiale, la première croissance C1 comprenant :
   ∘ une croissance normale par rapport à la surface de croissance 12 de manière à former une première couche de diamant monocristallin 10-1 comportant les défauts cristallins de la surface de croissance 12, et
   ∘ une croissance latérale par rapport à la paroi 11 délimitant la première gravure G1, de manière à former une deuxième couche de diamant monocristallin 10-2 comportant les défauts cristallins de la paroi 11 confinés dans la première figure de gravure G1 et une cavité 15, de sorte que, la première figure de gravure G1 est recouverte par une troisième couche de diamant monocristallin 10' présentant une densité de défauts cristallins inférieure ou égale à 10³ dislocations par cm²,

- formation de deuxièmes figures de gravure G2 par micro structuration de la première couche de diamant monocristallin 10-1 par ablation laser non traversante, de sorte que chaque deuxième figure de gravure G2 comprend une ouverture d'une largeur L2 prédéterminée et est délimitée par au moins une paroi 11', chacune des deuxièmes figures de gravure G2 présente en outre une profondeur P2 d'au moins 30 µm, ladite profondeur P2 étant supérieure à la largeur L2 de l'ouverture,
- une deuxième croissance C2 homoépitaxiale d'une autre deuxième couche de diamant monocristallin 10-2', la deuxième croissance C2 étant réalisée latéralement par rapport à la paroi 11' délimitant la deuxième figure de gravure G2, l'autre deuxième couche de diamant monocristallin 10-2' comportant les défauts cristallins de la paroi 11' confinés dans la deuxième figure de gravure G2 et une cavité 15', de sorte que, la deuxième figure de gravure G2 est recouverte par une troisième couche de diamant monocristallin 10' présentant une densité de défauts cristallins inférieure ou égale à 10³ défauts cristallins par cm².

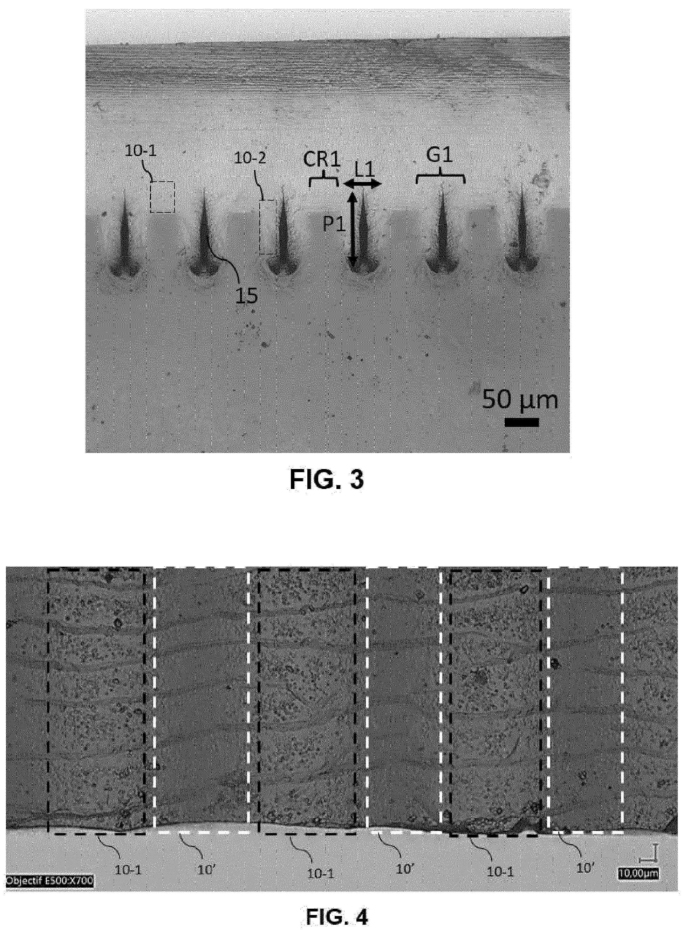

Les figures 3 et 4 montrent ainsi un substrat de diamant monocristallin 10 comprenant une couche de diamant monocristallin 10' obtenue selon l'invention, on peut observer à l'œil nu, sur la figure 4, que la première couche de diamant monocristallin 10-1 comporte bien plus de défauts cristallins que la couche de diamant monocristallin 10'.

## Revendications

1. **Procédé** de formation (100) d'une couche de diamant monocristallin (10') présentant une densité de défauts cristallins inférieure ou égale à 10³ défauts cristallins par cm² comprenant les étapes suivantes :
- fourniture (110) d'un substrat de diamant monocristallin (10) ayant une densité de défauts cristallins initiale supérieure à 10³ défauts cristallins par cm², le substrat de diamant monocristallin (10) présentant un angle de désorientation, par rapport à la face exacte du substrat de diamant monocristallin (10) supérieur à 0° et inférieur ou égal à 10°,
- première micro structuration (120) d'une surface de croissance (12) du substrat de diamant monocristallin (10) par ablation laser non traversante, l'étape de micro structuration (120) comportant la réalisation de premières figures de gravure (G1) de sorte que chaque première figure de gravure (G1) comprend une ouverture d'une largeur (L1) prédéterminée et est délimitée par au moins une paroi (11), chacune des premières figures de gravure (G1) présentant en outre une profondeur (P1) d'au moins 30 µm, ladite profondeur (P1) étant supérieure à la largeur (L1) de l'ouverture ;
- première croissance (C1) homoépitaxiale (130), dans un réacteur par dépôt chimique en phase vapeur assisté par plasma ou par filament chaud, la première croissance (C1) étant réalisée :
∘ normalement par rapport à la surface de croissance (12) de manière à former une première couche de diamant monocristallin (10-1) comportant les défauts cristallins de la surface de croissance (12), et
∘ latéralement par rapport à la paroi (11) délimitant la première gravure (G1), de manière à former une deuxième couche de diamant monocristallin (10-2) comportant les défauts cristallins de la paroi (11) confinés dans la première figure de gravure (G1) et une cavité (15), de sorte que, la première figure de gravure (G1) est recouverte par une troisième couche de diamant monocristallin (10') présentant une densité de défauts cristallins inférieure ou égale à 10³ dislocations par cm²,
- deuxième micro structuration (150) du substrat de diamant monocristallin (10) par ablation laser non traversante, ladite deuxième étape de micro structuration (150) comportant la réalisation de deuxièmes figures de gravure (G2) au niveau de la première couche de diamant monocristallin (10-1) comportant les défauts cristallins de la surface de croissance (12), chaque deuxième figure de gravure (G2) comprend une ouverture d'une largeur (L2) prédéterminée et est délimitée par au moins une paroi (11'), chacune des deuxièmes figures de gravure (G2) présente en outre une profondeur (P2) d'au moins 30 µm, ladite profondeur (P2) étant supérieure à la largeur (L2) de l'ouverture,
- deuxième croissance (C2) homoépitaxiale (160) d'une autre deuxième couche de diamant monocristallin (10-2'), dans un réacteur par dépôt chimique en phase vapeur assisté par plasma ou par filament chaud, la deuxième croissance (C2) étant réalisée latéralement par rapport à la paroi (11') délimitant la deuxième figure de gravure (G2), l'autre deuxième couche de diamant monocristallin (10-2') comportant les défauts cristallins de la paroi (11') confinés dans la deuxième figure de gravure (G2) et une cavité (15), de sorte que, la deuxième figure de gravure (G2) est recouverte par une troisième couche de diamant monocristallin (10') présentant une densité de défauts cristallins inférieure ou égale à 10³ défauts cristallins par cm².

2. Procédé selon la revendication 1 **caractérisé en ce que** la surface de croissance (12) est une face cristallographique 100 désorientée par rapport à une famille de faces cristallographiques {100} parallèles à une des faces latérales (13) du substrat de diamant monocristallin (10).

3. Procédé selon la revendication 1 **caractérisé en ce que** la surface de croissance (12) est une face cristallographique 100 désorientée par rapport à une famille de faces cristallographiques {110} ou à une famille de faces cristallographiques {113}.

4. Procédé selon l'une quelconque des revendications 1 à 3, **caractérisé en ce qu'**il comprend une étape de croissance (C3) homoépitaxiale normale (170), dans le réacteur par dépôt chimique en phase vapeur assisté par plasma ou par filament chaud, de sorte que la troisième couche de diamant monocristallin (10') atteigne une épaisseur d'au moins 500 µm.

5. Procédé selon la revendication 4, **caractérisé en ce qu'**il comprend une étape de découpe (180) de la troisième couche de diamant monocristallin (10'), de préférence au laser.

6. Procédé selon la revendication 5 **caractérisé en ce qu'**il comprend une étape de recuit (190) de la troisième couche de diamant monocristallin (10') à une température allant de 1500°C à 2300°C.

7. Procédé selon l'une quelconque des revendications 1 à 6, **caractérisé en ce qu'**il comprend au moins une étape de recuit intermédiaire du substrat de diamant monocristallin (10) à une température allant de 1500°C à 2300°C, l'étape de recuit intermédiaire étant mise en œuvre entre l'étape de fourniture (110) et l'étape de première micro structuration (120), entre la première croissance (C1) homoépitaxiale (130) et l'étape de deuxième micro structuration (150) et/ou entre l'étape de deuxième micro structuration (150) et l'étape de deuxième croissance (C2) homoépitaxiale (160).

8. Procédé selon l'une quelconque des revendications 1 à 7, **caractérisé en ce que** la largeur (L1, L2) de l'ouverture des première et deuxième figures de gravure (G1, G2) est comprise entre 20 µm et 200 µm.

9. Procédé selon l'une quelconque des revendications 1 à 8, ledit procédé comprenant une étape de préparation (140), préalable à la deuxième étape de micro-structuration (150), de la surface de croissance (12) du substrat de diamant monocristallin (10) par découpe laser ou par polissage, lorsque l'angle de désorientation est inférieur à un seuil prédéterminé, de façon à induire une désorientation au moins égale au seuil prédéterminé.

10. Procédé selon l'une quelconque des revendications 1 à 9, **caractérisé en ce que** les étapes de première et/ou deuxième micro-structuration (120, 150) et de première et/ou deuxième croissance homoépitaxiale (130, 160) sont répétées jusqu'à l'obtention d'une densité de défauts cristallins, dans la troisième couche de diamant monocristallin (10'), inférieure ou égale à un seuil prédéterminé, de préférence inférieure ou égale à 10³ défauts cristallins par cm² et de façon préférée inférieure ou égale à 5*10² défauts cristallins par cm².

11. Substrat de diamant monocristallin (10) ayant une densité de défauts cristallins initiale supérieure à 10³ défauts cristallins par cm², le substrat de diamant monocristallin (10) comprenant une surface de croissance (12) et :
- un angle de désorientation, par rapport à la face exacte dudit substrat supérieur à 0° et inférieur ou égal à 10°,
- des premières figures de gravure (G1) comprenant une première ouverture d'une largeur (L1) prédéterminée délimitée par au moins une première paroi (11), chacune des premières figures de gravure (G1) présentant en outre une profondeur (P1) d'au moins 30 µm, ladite profondeur (P1) étant supérieure à la largeur (L1) de la première ouverture, chacune des premières figures de gravure (G1) comprenant en outre une deuxième couche de diamant monocristallin (10-2), latérale par rapport à la première paroi (11), comportant les défauts cristallins de la première paroi (11) confinés dans la première figure de gravure (G1) par une première cavité (15),
- des deuxièmes figures de gravure (G2) comprenant une deuxième ouverture d'une largeur (L2) prédéterminée délimitée par au moins une deuxième paroi (11'), chacune des deuxièmes figures de gravure (G2) présente en outre une profondeur (P2) d'au moins 30 µm, ladite profondeur (P2) étant supérieure à la largeur (L2) de l'ouverture, chacune des deuxièmes figures de gravure (G2) comprenant en outre une autre deuxième couche de diamant monocristallin (10-2'), latérale par rapport à la deuxième paroi (11'), comportant les défauts cristallins de la deuxième paroi (11') confinés dans la deuxième figure de gravure (G2) par une deuxième cavité (15'),
- une troisième couche de diamant monocristallin (10'), qui recouvre les premières et deuxième figures de gravure (G1, G2), présentant une densité de défauts cristallins inférieure ou égale à 10³ défauts cristallins par cm².

12. Substrat de diamant monocristallin (10) selon la revendication 11, dans lequel les premières et deuxièmes figures de gravure (G1, G2) non traversantes sont réalisées sur toute la surface de croissance (12).

13. Substrat de diamant monocristallin (10) selon l'une des revendications 11 ou 12, dans lequel la largeur (L1, L2) de l'ouverture des première et deuxième figures de gravure (G1, G2) est comprise entre 20 µm et 200 µm.

14. Utilisation d'un substrat de diamant monocristallin (10) selon l'une quelconque des revendications 10 à 13 pour l'obtention d'une couche de diamant monocristallin (10') adaptée en tant que substrat pour des technologies quantiques, pour la fabrication d'une fenêtre optique, d'un substrat pour semi-conducteur ou pour la gestion thermique.

## Patentansprüche

1. Verfahren zur Herstellung (100) einer Schicht (10') aus monokristallinem Diamant, die eine Kristallfehlerdichte von kleiner oder gleich 10³ Kristallfehlern pro cm² aufweist, umfassend die folgenden Schritte:
- Bereitstellen (110) eines Substrats (10) aus monokristallinem Diamant, das eine anfängliche Kristallfehlerdichte von größer als 10³ Kristallfehlern pro cm² aufweist, wobei das Substrat (10) aus monokristallinem Diamant einen Fehlorientierungswinkel in Bezug auf die exakte Fläche des Substrats (10) aus monokristallinem Diamant von größer als 0° und kleiner oder gleich 10° aufweist;
- erstes Mikrostrukturieren (120) einer Wachstumsoberfläche (12) des Substrats (10) aus monokristallinem Diamant durch nicht durchdringende Laserablation, wobei der Schritt des Mikrostrukturierens (120) das Ausführen erster Ätzfiguren (G1) umfasst, derart dass jede erste Ätzfigur (G1) eine Öffnung mit einer vorbestimmten Breite (L1) umfasst und von mindestens einer Wand (11) abgegrenzt ist, wobei jede der ersten Ätzfiguren (G1) ferner eine Tiefe (P1) von mindestens 30 µm aufweist, wobei die Tiefe (P1) größer als die Breite (L1) der Öffnung ist;
- erstes homoepitaktisches (130) Wachsen (C1) in einem plasma- oder heißfilamentunterstützten chemischen Gasphasenabscheidungsreaktor, wobei das erste Wachsen (C1) ausgeführt wird:
∘ normal in Bezug auf die Wachstumsoberfläche (12), derart dass eine erste Schicht (10-1) aus monokristallinem Diamant gebildet wird, welche die Kristallfehler der Wachstumsoberfläche (12) umfasst, und
∘ seitlich in Bezug auf die Wand (11), welche die erste Ätzung (G1) abgrenzt, derart dass eine zweite Schicht (10-2) aus monokristallinem Diamant gebildet wird, welche die Kristallfehler der Wand (11), die in der ersten Ätzfigur (G1) eingegrenzt sind, und einen Hohlraum (15) umfasst, derart dass die erste Ätzfigur (G1) von einer dritten Schicht (10') aus monokristallinem Diamant bedeckt ist, die eine Kristallfehlerdichte von kleiner oder gleich 10³ Dislokationen pro cm² aufweist,
- zweites Mikrostrukturieren (150) des Substrats (10) aus monokristallinem Diamant durch nicht durchdringende Laserablation, wobei der zweite Mikrostrukturierungsschritt (150) das Ausführen zweiter Ätzfiguren (G2) im Bereich der ersten Schicht (10-1) aus monokristallinem Diamant umfasst, welche die Kristallfehler der Wachstumsoberfläche (12) umfasst, wobei jede zweite Ätzfigur (G2) eine Öffnung mit einer vorbestimmten Breite (L2) aufweist und von mindestens einer Wand (11') abgegrenzt ist, wobei jede der zweiten Ätzfiguren (G2) ferner eine Tiefe (P2) von mindestens 30 µm aufweist, wobei die Tiefe (P2) größer als die Breite (L2) der Öffnung ist,
- zweites homoepitaktisches (160) Wachsen (C2) einer anderen zweiten Schicht (10-2') aus monokristallinem Diamant in einem plasma- oder heißfilamentunterstützten chemischen Gasphasenabscheidungsreaktor, wobei das zweite Wachsen (C2) seitlich in Bezug auf die Wand (11') ausgeführt wird, welche die zweite Ätzfigur (G2) abgrenzt, wobei die andere zweite Schicht (10-2') aus monokristallinem Diamant die Kristallfehler der Wand (11'), die in der zweiten Ätzfigur (G2) eingegrenzt sind, und einen Hohlraum (15) umfasst, derart dass die zweite Ätzfigur (G2) von einer dritten Schicht (10') aus monokristallinem Diamant bedeckt ist, die eine Kristallfehlerdichte von kleiner oder gleich 10³ Kristallfehlern pro cm² aufweist.

2. Verfahren nach Anspruch 1, **dadurch gekennzeichnet, dass** die Wachstumsschicht (12) eine kristallographische Fläche (100) ist, die in Bezug auf eine Familie von kristallographischen Flächen (100) fehlorientiert ist, die parallel zu einer der seitlichen Flächen (13) des Substrats (10) aus monokristallinem Diamant ist.

3. Verfahren nach Anspruch 1, **dadurch gekennzeichnet, dass** die Wachstumsoberfläche (12) eine kristallographische Fläche (100) ist, die in Bezug auf eine Familie von kristallographischen Flächen (110) oder eine Familie von kristallographischen Flächen (113) fehlorientiert ist.

4. Verfahren nach einem der Ansprüche 1 bis 3, **dadurch gekennzeichnet, dass** es einen Schritt des normalen homoepitaktischen (170) Wachsens (C3) in dem plasma- oder heißfilamentunterstützten chemischen Gasphasenabscheidungsreaktor umfasst, derart dass die dritte Schicht (10') aus monokristallinem Diamant eine Dicke von mindestens 500 µm erreicht.

5. Verfahren nach Anspruch 4, **dadurch gekennzeichnet, dass** es einen Schritt des Schneidens (180) der dritten Schicht (10') aus monokristallinem Diamant, vorzugsweise mit Laser, umfasst.

6. Verfahren nach Anspruch 5, **dadurch gekennzeichnet, dass** es einen Schritt des Glühens (190) der dritten Schicht (10') aus monokristallinem Diamant bei einer Temperatur zwischen 1500 °C und 2300 °C umfasst.

7. Verfahren nach einem der Ansprüche 1 bis 6, **dadurch gekennzeichnet, dass** es mindestens einen Schritt des Zwischenglühens des Substrats (10) aus monokristallinem Diamant bei einer Temperatur zwischen 1500 °C und 2300 °C umfasst, wobei der Schritt des Zwischenglühens zwischen dem Schritt des Bereitstellens (110) und dem Schritt des ersten Mikrostrukturierens (120) zwischen dem ersten homoepitaktischen (130) Wachsen (C1) und dem Schritt des zweiten Mikrostrukturierens (150) und/oder zwischen dem Schritt des zweiten Mikrostrukturierens (150) und dem Schritt des zweiten homoepitaktischen (160) Wachsens (C2) umfasst.

8. Verfahren nach einem der Ansprüche 1 bis 7, **dadurch gekennzeichnet, dass** die Breite (L1, L2) der Öffnung der ersten und der zweiten Ätzfigur (G1, G2) zwischen 20 µm und 200 µm beträgt.

9. Verfahren nach einem der Ansprüche 1 bis 8, wobei das Verfahren vor dem zweiten Schritt des Mikrostrukturierens (150) einen Schritt des Vorbereitens (140) der Wachstumsoberfläche (12) des Substrats (10) aus monokristallinem Diamant durch Laserschneiden oder durch Polieren umfasst, wenn der Fehlorientierungswinkel kleiner als ein vorbestimmter Schwellenwert ist, derart dass eine Fehlorientierung bewirkt wird, die mindestens gleich dem vorbestimmten Schwellenwert ist.

10. Verfahren nach einem der Ansprüche 1 bis 9, **dadurch gekennzeichnet, dass** die Schritte des ersten und/oder zweiten Mikrostrukturierens (120, 150) und des ersten und/oder zweiten homoepitaktischen Wachsens (130, 160) bis zum Erhalt einer Kristallfehlerdichte in der dritten Schicht (10') aus monokristallinem Diamant wiederholt werden, die kleiner oder gleich einem vorbestimmten Schwellenwert, vorzugsweise kleiner oder gleich 10³ Kristallfehlern pro cm² und bevorzugter kleiner oder gleich 5*10² Kristallfehlern pro cm² ist.

11. Substrat (10) aus monokristallinem Diamant, das eine anfängliche Kristallfehlerdichte von größer als 10³ Kristallfehlern pro cm² aufweist, wobei das Substrat (10) aus monokristallinem Diamant eine Wachstumsoberfläche (12) und Folgendes umfasst:
- einen Fehlorientierungswinkel in Bezug auf die exakte Fläche des Substrats von größer als 0° und kleiner oder gleich 10°,
- erste Ätzfiguren (G1), die eine erste Öffnung mit einer vorbestimmten Breite (L1) umfassen, die von mindestens einer ersten Wand (11) abgegrenzt ist, wobei jede der ersten Ätzfiguren (G1) ferner eine Tiefe (P1) von mindestens 30 µm aufweist, wobei die Tiefe (P1) größer als die Breite (L1) der ersten Öffnung ist, wobei jede der ersten Ätzfiguren (G1) ferner eine zweite Schicht (10-2) aus monokristallinem Diamant umfasst, die seitlich in Bezug auf die erste Wand (11) ist und Kristallfehler der ersten Wand (11) umfasst, die in der ersten Ätzfigur (G1) durch einen ersten Hohlraum (15) eingegrenzt sind,
- zweite Ätzfiguren (G2), die eine zweite Öffnung mit einer vorbestimmten Breite (L2) umfassen, die von mindestens einer zweiten Wand (11') abgegrenzt ist, wobei jede der zweiten Ätzfiguren (G2) ferner eine Tiefe (P2) von mindestens 30 µm aufweist, wobei die Tiefe (P2) größer als die Breite (L2) der Öffnung ist, wobei jede der zweiten Ätzfiguren (G2) ferner eine andere zweite Schicht (10-2') aus monokristallinem Diamant umfasst, die seitlich in Bezug auf die zweite Wand (11') ist und Kristallfehler der zweiten Wand (11') umfasst, die in der zweiten Ätzfigur (G2) durch einen zweiten Hohlraum (15') eingegrenzt sind,
- eine dritte Schicht (10') aus monokristallinem Diamant, welche die erste und die zweite Ätzfigur (G1, G2) bedeckt und eine Kristallfehlerdichte von kleiner oder gleich 10³ Kristallfehlern pro cm² aufweist.

12. Substrat (10) aus monokristallinem Diamant nach Anspruch 11, wobei die erste und die zweite nicht durchdringende Ätzfigur (G1, G2) auf der gesamten Wachstumsoberfläche (12) hergestellt sind.

13. Substrat (10) aus monokristallinem Diamant nach einem der Ansprüche 11 oder 12, wobei die Breite (L1, L2) der Öffnung der ersten und der zweiten Ätzfigur (G1, G2) zwischen 20 µm und 200 µm beträgt.

14. Verwendung eines Substrats (10) aus monokristallinem Diamant nach einem der Ansprüche 10 bis 13 zum Erhalt einer Schicht (10') aus monokristallinem Diamant, die als Substrat für Quantentechnologien, zur Herstellung eines optischen Fensters, eines Substrats für Halbleiter oder zum Wärmemanagement angepasst ist.

## Claims

1. A method for forming (100) a single-crystal diamond layer (10') having a crystal defect density less than or equal to 10³ crystal defects per cm² comprising the following steps:
- provision (110) of a single-crystal diamond substrate (10) having an initial crystal defect density greater than 10³ crystal defects per cm², the single-crystal diamond substrate (10) having a disorientation angle, with respect to the exact face of the single-crystal diamond substrate (10) greater than 0° and less than or equal to 10°,
- first microstructuring (120) of a growth surface (12) of the single-crystal diamond substrate (10) by non-penetrating laser ablation, the microstructuring step (120) including the creation of first etch patterns (G1) such that each first etch pattern (G1) comprises an opening of a predetermined width (L1) and is delimited by at least one wall (11), each of the first etch patterns (G1) also having a depth (P1) of at least 30 µm, said depth (P1) being greater than the width (L1) of the opening;
- first homoepitaxial (130) growth (C1), in a plasma-assisted or hot-filament-assisted chemical vapor deposition reactor, the first growth (C1) being carried out:
∘ normally with respect to the growth surface (12) so as to form a first single-crystal diamond layer (10-1) including the crystalline defects of the growth surface (12), and
∘ laterally with respect to the wall (11) delimiting the first etch (G1), so as to form a second single-crystal diamond layer (10-2) including the crystalline defects of the wall (11) confined within the first etch pattern (G1) and a cavity (15), so that the first etch pattern (G1) is covered by a third single-crystal diamond layer (10') having a density of crystalline defects less than or equal to 10³ dislocations per cm²,
- second microstructuring (150) of the single-crystal diamond substrate (10) by non-penetrating laser ablation, said second microstructuring step (150) including the creation of second etch patterns (G2) at the first single-crystal diamond layer (10-1) including the crystalline defects of the growth surface (12), each second etch pattern (G2) comprises an opening of a predetermined width (L2) and is delimited by at least one wall (11'), each of the second etch patterns (G2) furthermore has a depth (P2) of at least 30 µm, said depth (P2) being greater than the width (L2) of the opening,
- second homoepitaxial (160) growth (C2) of another second single-crystal diamond layer (10-2), in a plasma-assisted or hot-filament-assisted chemical vapor deposition reactor, the second growth (C2) being carried out laterally with respect to the wall (11') delimiting the second etch pattern (G2), the other second single-crystal diamond layer (10-2') having the crystal defects of the wall (11') confined in the second etch pattern (G2) and a cavity (15), so that, the second etch pattern (G2) is covered by a third single-crystal diamond layer (10') having a crystal defect density less than or equal to 10³ crystal defects per cm².

2. The method according to claim 1 **characterized in that** the growth surface (12) is a crystallographic face 100 disoriented with respect to a family of crystallographic faces {100} parallel to one of the lateral faces (13) of the single-crystal diamond substrate (10).

3. The method according to claim 1 **characterized in that** the growth surface (12) is a crystallographic face 100 disoriented with respect to a family of crystallographic faces {110} or to a family of crystallographic faces {113}.

4. The method according to any one of claims 1 to 3, **characterized in that** it comprises a step of normal homoepitaxial (170) growth (C3), in the reactor by plasma-assisted or hot-filament-assisted chemical vapor deposition, such that the third single-crystal diamond layer (10') reaches a thickness of at least 500 µm.

5. The method according to claim 4, **characterized in that** it comprises a step (180) of cutting the third single-crystal diamond layer (10'), preferably by laser.

6. The method according to claim 5 **characterized in that** it comprises a step (190) of annealing the third single-crystal diamond layer (10') at a temperature ranging from 1500°C to 2300°C.

7. The method according to any one of claims 1 to 6, **characterized in that** it comprises at least one intermediate step of annealing the single-crystal diamond substrate (10) at a temperature ranging from 1500°C to 2300°C, the intermediate annealing step being carried out between the provision step (110) and the first microstructuring step (120), between the first homoepitaxial (130) growth (C1) and the second microstructuring step (150) and/or between the second microstructuring step (150) and the step of second homoepitaxial (160) growth (C2).

8. The method according to any one of claims 1 to 7, **characterized in that** the width (L1, L2) of the opening of the first and second etch patterns (G1, G2) is comprised between 20 µm and 200 µm.

9. The method according to any one of claims 1 to 8, said method comprising a step (140), prior to the second micro-structuring step (150), of preparing the growth surface (12) of the single-crystal diamond substrate (10) by laser cutting or by polishing, when the angle of disorientation is less than a predetermined threshold, so as to induce a disorientation at least equal to the predetermined threshold.

10. The method according to any one of claims 1 to 9, **characterized in that** the first and/or second microstructuring steps (120, 150) and first and/or second homoepitaxial growth steps (130, 160) are repeated until a density of crystalline defects is obtained in the third single-crystal diamond layer (10'), less than or equal to a predetermined threshold, preferably less than or equal to 10³ crystalline defects per cm² and preferably less than or equal to 5*10² crystalline defects per cm².

11. A single-crystal diamond substrate (10) having an initial crystal defect density greater than 10³ crystal defects per cm², the single-crystal diamond substrate (10) comprising a growth surface (12) and:
- an angle of disorientation, with respect to the exact face of said substrate, greater than 0° and less than or equal to 10°,
- first etch patterns (G1) comprising a first opening of a predetermined width (L1) delimited by at least one first wall (11), each of the first etch patterns (G1) further having a depth (P1) of at least 30 µm, said depth (P1) being greater than the width (L1) of the first opening, each of the first etch patterns (G1) further comprising a second single-crystal diamond layer (10-2), lateral with respect to the first wall (11), including the crystalline defects of the first wall (11) confined in the first etch pattern (G1) by a first cavity (15),
- second etch patterns (G2) comprising a second opening of a predetermined width (L2) delimited by at least one second wall (11'), each of the second etch patterns (G2) further having a depth (P2) of at least 30 µm, said depth (P2) being greater than the width (L2) of the opening, each of the second etch patterns (G2) further comprising another second single-crystal diamond layer (10-2'), lateral with respect to the second wall (11'), comprising the crystalline defects of the second wall (11') confined in the second etch pattern (G2) by a second cavity (15'),
- a third single-crystal diamond layer (10'), which covers the first and second etch patterns (G1, G2), having a density of crystalline defects less than or equal to 10³ crystalline defects per cm².

12. The single crystal diamond substrate (10) according to claim 11, wherein the first and second non-through etch patterns (G1, G2) are made over the entire growth surface (12).

13. The single crystal diamond substrate (10) according to any one of claims 11 or 12, wherein the width (L1, L2) of the opening of the first and second etch patterns (G1, G2) is comprised between 20 µm and 200 µm.

14. A use of a single-crystal diamond substrate (10) according to any one of claims 10 to 13 for obtaining a single-crystal diamond layer (10') suitable as a substrate for quantum technologies, for the manufacture of an optical window, a substrate for semiconductors or for thermal management.
